# DEMANDE DE BREVET EUROPEEN

(11) **EP 4 006 203 A1**
(43) Date de publication de la demande: **01.06.2022**
(21) Numéro de dépôt: 21210678.5
(22) Date de dépôt: 26.11.2021
(51) Int. Cl.: C23F 1/02, C23F 1/26, C23F 4/00, H01L 45/00

(54) **PROCÉDÉ POUR AUGMENTER LA RUGOSITÉ DE SURFACE D'UNE COUCHE MÉTALLIQUE**

(30) Priorité: 27.11.2020 FR 2012282
(71) Demandeur: Commissariat à l'Energie Atomique et aux Energies Alternatives, 75015 Paris (FR)
(72) Inventeur: POSSEME, Nicolas, 38054 GRENOBLE CEDEX 09 (FR); GRENOUILLET, Laurent, 38054 GRENOBLE CEDEX 09 (FR); POLLET, Olivier, 38054 GRENOBLE CEDEX 09 (FR)
(74) Mandataire: Cabinet Camus Lebkiri

(57) **Abrégé**

L'invention concerne un procédé pour augmenter la rugosité de surface d'une couche à base d'un métal (10) ayant un pouvoir catalytique, comprenant les étapes suivantes :
- fixer (S11) du fluor ou du chlore à la surface de la couche à base de métal (10), en exposant la couche à base de métal (10) à un plasma formé à partir d'un gaz réactif contenant du fluor ou du chlore ;
- exposer (S11) la surface de la couche à base de métal (10) à un environnement humide pour produire un acide, par réaction de l'hydrogène de l'environnement humide avec le fluor ou le chlore fixé à la surface de la couche à base de métal, l'acide réagissant avec le métal pour former des résidus, l'ensemble des résidus formant un motif (12) à la surface de la couche à base de métal (10) ;
- graver la couche à base de métal (10) à travers les résidus (11), de façon à transférer le motif (12) dans la couche à base de métal (10).

## Description

### DOMAINE TECHNIQUE

La présente invention concerne un procédé pour augmenter la rugosité de surface d'une couche métallique et son application lors de la fabrication d'une cellule mémoire résistive.

### ÉTAT DE LA TECHNIQUE

Dans un dispositif électronique de type métal-isolant-métal (MIM) comme un condensateur ou une cellule de mémoire résistive, la rugosité de surface des couches métalliques formant les électrodes peut avoir un impact significatif sur les propriétés électriques du dispositif.

Par exemple, dans une cellule de mémoire résistive à base d'oxyde (OxRAM, pour « Oxide-based Random Access Memory » en anglais) comprenant une électrode inférieure, une électrode supérieure et un matériau actif de résistance électrique variable disposé entre les électrodes, la rugosité de l'électrode inférieure influe sur la tension dite de forming de la cellule mémoire. La tension de forming d'une cellule OxRAM est la valeur de tension à laquelle la cellule mémoire bascule d'un état vierge, caractérisé par une résistance (dite initiale) très élevée, à un état faiblement résistif. La tension de forming est supérieure à la tension nominale de fonctionnement de la cellule mémoire, qui permet d'effacer ou d'écrire la cellule mémoire (passage de l'état faiblement résistif à un état fortement résistif, ou inversement).

Dans l'article [« Impact of roughness of TiN bottom electrode on the forming voltage of HfO2 based resistive memories », Microelectronic Engineering, 2020, vol. 221, p. 111194], C. Charpin-Nicolle et al. montrent qu'augmenter la rugosité de l'électrode inférieure en nitrure de titane (TiN) a pour effet de diminuer la tension de forming de la cellule mémoire. Une tension de forming plus faible est avantageuse, car elle permet de réduire la taille du circuit mémoire (transistors de sélection, circuit générateur de tensions) et d'améliorer l'endurance des cellules mémoire.

L'électrode inférieure en TiN est rendue plus rugueuse par exposition à un plasma de gravure ionique réactive (aussi appelée RIE, pour « Reactive-Ion Etching » en anglais). Différentes chimies de plasma associées chacune à des conditions particulières de gravure ont permis de faire varier la rugosité de surface en valeur moyenne quadratique de 0,4 nm à 14 nm.

L'augmentation de la rugosité par RIE nécessite cependant de développer une recette spécifique pour chaque matériau d'électrode, en jouant sur les nombreux paramètres de procédé (mélange de gaz réactifs et concentrations, pression, puissances RF, températures...). Cependant, pour certains métaux, il s'avère impossible de générer de la rugosité par RIE, aucun jeu de paramètres ne permettant d'activer un mécanisme de gravure aléatoire et non-uniforme.

Par ailleurs, le document EP1475848A1 divulgue un procédé de gravure d'un empilement de couches pour la fabrication de cellules mémoire à changement de phase. L'empilement comprend notamment une première couche de titane, une couche de matériau à changement de phase (GST) disposée sur la première couche de titane, une deuxième couche de titane disposée sur la couche de matériau à changement de phase et une couche d'aluminium-cuivre (AlCu) disposée sur la deuxième couche de titane. Le procédé comprend plusieurs étapes de gravure, dont :
- une première étape de gravure plasma Cl₂+BCl₃+N₂ pour graver l'empilement jusqu'à atteindre la deuxième couche de titane ;
- une deuxième étape de gravure plasma Cl₂+BCl₃+Ar+O₂+N₂ pour graver l'empilement jusqu'à atteindre la première couche de titane.

Le procédé comprend également, entre ces deux étapes de gravure, une étape de formation d'une couche de passivation en alumine (Al₂O₃) sur les flancs de la couche d'AICu, par exposition à un plasma H₂O.

### RÉSUMÉ DE L'INVENTION

Il existe un besoin de prévoir un procédé pour augmenter la rugosité de surface d'une couche à base de métal, qui soit simple à mettre en œuvre et applicable à plusieurs métaux.

Selon un premier aspect de l'invention, on tend à satisfaire ce besoin en prévoyant un procédé dit « de rugosification » comprenant les étapes suivantes :
- fixer du fluor ou du chlore à la surface de la couche à base de métal, en exposant la couche à base de métal à un plasma formé à partir d'un gaz réactif contenant du fluor ou du chlore ;
- exposer la surface de la couche à base de métal à un environnement humide pour produire un acide, par réaction de l'hydrogène de l'environnement humide avec le fluor ou le chlore fixé à la surface de la couche à base de métal, l'acide réagissant avec le métal pour former des résidus, l'ensemble des résidus formant un motif à la surface de la couche à base de métal ;
- graver la couche à base de métal à travers les résidus, de façon à transférer le motif dans la couche à base de métal.

Ce procédé permet d'augmenter la rugosité d'une couche métallique sans avoir besoin de développer une recette de gravure plasma spécifique à chaque métal, car la rugosité est générée en surface de la couche à base de métal, par croissance de résidus (ou dépôts) constitués d'un sel métallique, avant d'être transférée dans la couche à base de métal. Un procédé de gravure classique (c'est-à-dire non optimisé pour la génération de rugosité) peut être employé pour accomplir ce transfert.

De préférence, la couche à base de métal est gravée au moyen d'un procédé de gravure ayant une sélectivité par rapport aux résidus comprise entre 1 et 2.

La couche à base de métal est avantageusement gravée jusqu'à retirer tous les résidus.

Le métal est de préférence choisi parmi le titane (Ti), le nitrure de titane (TiN), le tantale (Ta) et le nitrure de tantale (TaN).

Le gaz réactif peut être un gaz non polymérisant contenant du fluor, par exemple l'hexafluorure de soufre (SF₆) ou le trifluorure d'azote (NF₃).

Alternativement, le plasma est formé à partir d'un mélange de gaz réactifs comprenant un gaz fluorocarboné (CₓF_{Y}) et un gaz dépolymérisant.

L'environnement humide peut être l'air ambiant ou généré dans une chambre d'un réacteur plasma.

Le procédé de rugosification peut comprendre en outre une étape d'oxydation de la surface de la couche à base de métal avant l'étape de formation des résidus.

Un deuxième aspect de l'invention concerne un procédé de fabrication d'une cellule mémoire résistive comprenant une première électrode, une deuxième électrode et une couche résistive disposée entre les première et deuxième électrodes, le procédé comprenant les étapes suivantes :
- déposer une première couche métallique sur un substrat ;
- augmenter la rugosité de la première couche métallique au moyen d'un procédé selon le premier aspect de l'invention ;
- déposer une couche de matériau à résistance électrique variable sur la première couche métallique et une deuxième couche métallique sur la couche de matériau à résistance électrique variable ;
- graver la première couche métallique, la couche de matériau à résistance électrique variable et la deuxième couche métallique, de façon à délimiter respectivement la première électrode, la couche résistive et la deuxième électrode de la cellule mémoire résistive.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures suivantes.
[Fig. 1A] et [Fig. 1B] représentent des étapes d'un procédé pour augmenter la rugosité de surface d'une couche de métal ;
[Fig. 2A], [Fig. 2B] et [Fig. 2C] représentent des étapes d'un procédé de fabrication d'une cellule mémoire résistive, dans lequel le procédé des figures 1A-1B est mis en œuvre.

Pour plus de clarté, les éléments identiques ou similaires sont repérés par des signes de référence identiques sur l'ensemble des figures.

### DESCRIPTION DÉTAILLÉE

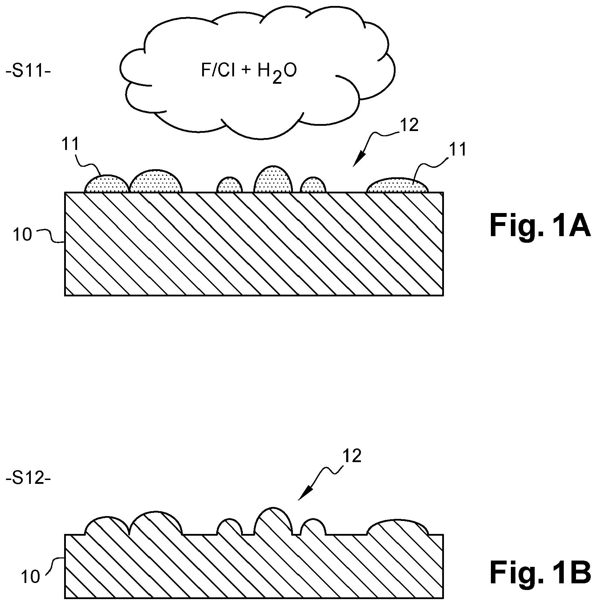

Les figures 1A et 1B représentent schématiquement des étapes S11 et S12 d'un procédé pour augmenter la rugosité d'une couche 10 à base d'un métal ayant un pouvoir catalytique, aussi appelée couche métallique 10. Par couche métallique, on entend une couche formée d'un matériau dont les atomes sont unis par des liaisons métalliques.

La couche métallique 10 peut être constituée soit d'un métal, soit d'un alliage métallique, soit d'un composé métallique, soit encore d'un mélange de plusieurs composés métalliques. Cette couche est préférentiellement à base de titane, de tantale, de tungstène, d'or, de nickel et/ou d'aluminium. Il peut donc s'agir d'une couche en titane, d'une couche en tantale, d'une couche en tungstène, d'une couche en or, d'une couche en nickel, d'une couche en aluminium, d'une couche en un alliage d'au moins deux de ces métaux, d'une couche en un composé de titane, de tantale, de tungstène, d'or, de nickel et/ou d'aluminium, ou bien encore d'une couche en un mélange de plusieurs composés de titane, de tantale, de tungstène, d'or, de nickel et/ou d'aluminium. De préférence, la couche à base de métal est en titane, en tantale, en nitrure de titane, en nitrure de tantale, en oxynitrure de titane ou en oxynitrure de tantale.

La couche métallique 10 peut être disposée sur un substrat (non représenté), par exemple en silicium. Elle est par exemple formée par dépôt physique en phase vapeur (ou PVD, pour « Physical Vapor Déposition » en anglais). Son épaisseur est de préférence supérieure ou égale à 100 nm.

La couche métallique 10 présente initialement (c.-à-d. immédiatement après son dépôt) une rugosité de surface strictement inférieure à 1 nm. Cette valeur de rugosité, ainsi que toutes celles données par la suite, sont exprimées en valeur moyenne quadratique. La rugosité moyenne quadratique (notée Rq) est déterminée par une analyse statistique d'une image de microscope à force atomique, en prenant comme échantillon une surface de 5x5 µm².

En référence à la figure 1A, le procédé d'augmentation de la rugosité, aussi appelé procédé de rugosification, comprend une première étape S11 de formation de résidus 11 sur une surface de la couche métallique 10. Les résidus 11 sont des excroissances de forme aléatoire et répartis de manière non uniforme à la surface de la couche métallique 10. Ensemble, ils forment un motif (ou « pattern ») 12 à la surface de la couche métallique 10.

Les résidus 11 sont constitués d'un sel métallique (résidus oxyfluorures métalliques ou résidus oxychlorures métalliques) et produits par une réaction chimique du métal avec un acide contenant du fluor ou du chlore, par exemple l'acide fluorhydrique (HF) ou l'acide chlorhydrique (HCI).

Dans un premier mode de mise en œuvre de l'étape S11, les résidus 11 sont formés par exposition de la couche métallique 10 à une solution aqueuse d'acide fluorhydrique (HF) ou d'acide chlorhydrique (HCI). A titre d'exemple, la surface de la couche métallique 10 est plongée dans une solution de HF de concentration comprise entre 1 % et 5 % pendant une durée comprise entre 30 s et 120 s.

Dans un deuxième mode de mise en œuvre, les résidus 11 sont formés par exposition de la couche métallique 10 à un plasma, puis à un environnement humide. Le plasma est formé à partir d'un gaz réactif contenant du fluor ou du chlore.

Le fluor (respectivement le chlore) contenu dans le plasma se fixe sur la surface de la couche métallique 10 lors d'une première opération dite de « fluoration » (respectivement de « chloration »), puis réagit avec l'hydrogène de l'environnement humide lors d'une deuxième opération pour produire l'acide. Ensuite, l'acide réagit avec le métal de la couche 10 pour former les résidus 11. Ce mécanisme de formation des résidus 11 est décrit en détail dans le document [« Residue growth on metallic-hard mask after dielectric etching in fluorocarbon-based plasmas. I. Mechanisms », N. Posseme et al., Journal of vacuum science & technology B 28(4), pp.809-816, 2010] incorporé ici à titre de référence.

Le plasma utilisé dans le deuxième mode de mise en œuvre de l'étape S11 n'a aucun rôle gravant, contrairement aux plasmas utilisés dans le procédé de gravure du document EP1475848A1. Autrement dit, il ne grave pas la couche métallique 10. Son rôle est uniquement de fixer le chlore ou le fluor à la surface de la couche métallique 10, afin d'obtenir une surface riche en fluor/chlore.

Le plasma peut être formé dans tout type de réacteur plasma, par exemple un réacteur de gravure ionique réactive (RIE, pour « Reactive-lon Etching » en anglais). Un réacteur RIE comprend notamment une chambre dans laquelle est généré le plasma, une antenne radiofréquence (RF) appelée « générateur source » et un porte-substrat appelé « générateur bias », sur lequel est disposé le substrat (recouvert de la couche métallique 10). Le porte-substrat permet d'appliquer une polarisation au substrat.

De préférence, le gaz réactif utilisé pour former le plasma est un gaz non polymérisant contenant du fluor, tel que l'hexafluorure de soufre (SF₆) ou le trifluorure d'azote (NF₃).

Le plasma peut être généré dans un réacteur RIE dans les conditions suivantes :
- un débit de SF₆ compris entre 10 sccm et 100 sccm (abréviation de « Standard Cubic Centimeter per Minute » en anglais, soit le nombre de cm³ de gaz s'écoulant par minute dans les conditions standard de pression et de température, i.e. à une température de 0 °C et une pression de 1013,25 hPa) ;
- une puissance émise par la source du réacteur comprise entre 100 W et 1000 W ;
- une tension de polarisation du substrat comprise entre 0 V et 100 V, avantageusement comprise entre 0 V et 20 V, par exemple égale à 0 V (afin de limiter voire éviter la gravure de la couche métallique) ;
- une pression dans la chambre du réacteur comprise entre 0,667 Pa (5 mTorr) et 13,332 Pa (100 mTorr) ;
- une température de porte-substrat comprise entre 10 °C et 100 °C ; et
- une température des parois de la chambre du réacteur supérieure ou égale à 100 °C, par exemple comprise entre 100 °C et 150 °C.

La durée d'exposition de la couche métallique 10 au plasma est déterminée en fonction de la densité des résidus 11 qu'on cherche à obtenir à l'issue de l'étape S11 (et qui conditionne la rugosité de surface finale de la couche métallique 10). Pour les plages de paramètre décrits précédemment, elle est typiquement comprise entre 30 s et 120 s.

Le plasma peut être également formé à partir d'un mélange de plusieurs gaz réactifs introduits dans la chambre du réacteur. Le mélange de gaz réactifs comprend un gaz fluorocarboné (CₓF_{Y}), avantageusement hydrogéné (CₓH_{y}F_{z}), et un gaz dépolymérisant, tel que le dioxygène (O₂) ou le diazote (N₂). Le gaz dépolymérisant empêche le dépôt d'un matériau polymère (c.-à-d. carboné) sur la couche métallique 10. Le rapport du débit de gaz fluorocarboné sur le débit de gaz dépolymérisant est de préférence compris entre 0,5 et 1.

Après l'opération de fluoration/chloration, le substrat peut être extrait du réacteur plasma et exposé à l'air ambiant, qui est chargé en humidité. Les résidus 11 commencent à se former à la surface de la couche métallique 10 environ une heure après la remise à l'air (temps variable selon le taux d'humidité).

Alternativement, l'environnement humide est généré dans le réacteur plasma (autrement dit *in situ*). Après avoir accompli l'opération de fluoration/chloration dans une première chambre du réacteur, le substrat est déplacé dans une deuxième chambre remplie de vapeur d'eau pour effectuer la deuxième opération.

L'exposition de la couche métallique 10 à l'environnement humide (deuxième opération de l'étape S11 ; par remise à l'air ou dans le réacteur plasma) est de préférence accomplie à température ambiante. A l'inverse, les plasmas de vapeur d'eau habituellement utilisés pour nettoyer les surfaces (et notamment pour faire désorber les espèces présentes en surface, telle que le chlore et le fluor) ou pour former une couche d'oxyde de passivation sont formés à des températures de l'ordre de 100 °C à 200 °C.

D'une manière générale, le deuxième mode de mise en œuvre de l'étape S11 (formation des résidus 11 par voie sèche) est plus rapide et plus simple à mettre en œuvre que le premier mode de mise en œuvre (par voie humide). Il procure en outre un meilleur contrôle sur la taille et la densité des résidus 11.

L'étape suivante S12, représentée par la figure 1B, consiste à graver la couche métallique 10 à travers les résidus 11, de façon à transférer le motif 12 formé les résidus 11 dans la couche métallique 10. Autrement dit, les résidus 11 sont utilisés comme un masque dur pour graver la couche métallique 10.

Le transfert du motif 12 dans la couche métallique 10 a pour effet d'augmenter la rugosité de surface de la couche métallique 10, jusqu'à une valeur finale supérieure ou égale à 10 nm, et de préférence comprise entre 10 nm et 30 nm (bornes incluses).

La couche métallique 10 est de préférence gravée au moyen d'un procédé de gravure peu sélectif par rapport aux résidus 11, c'est-à-dire ayant une sélectivité comprise entre 1 et 2 (bornes comprises). Le motif 12 est ainsi transféré dans la couche métallique 10 sensiblement à l'identique.

La couche métallique 10 est avantageusement gravée jusqu'à supprimer tous les résidus 11 (autrement dit jusqu'à consommer tout le masque dur). On s'affranchit ainsi d'une étape supplémentaire de retrait des résidus 11 de manière sélective par rapport à la couche métallique 10.

L'étape S12 de gravure de la couche métallique 10 peut être accomplie par gravure ionique réactive (RIE). En particulier, elle peut être accomplie dans le même réacteur plasma que celui utilisé pour former les résidus 11 (étape S11), afin de simplifier encore le procédé du rugosification. Par exemple, la gravure des métaux Ti, Ta, TiN et TaN est possible par RIE en utilisant une chimie à base de chlore ou de fluor.

Le procédé de rugosification des figures 1A-1B est applicable à plusieurs métaux (en particulier Ti, Ta, TiN et TaN) et ne nécessite pas de développer un recette de gravure plasma spécifique à chaque métal. En outre, il est particulièrement simple à mettre œuvre.

Selon un premier exemple de mise en œuvre du procédé de rugosification, la couche métallique 10 est en TiN, les résidus 11 sont formés à l'étape S11 par réaction avec un acide contenant du fluor (ex. plasma CF₆ + environnement humide ou solution aqueuse de HF) et la couche métallique 10 est gravée à l'étape S12 par un plasma RIE à base de chlore.

Selon un deuxième exemple de mise en œuvre, la couche métallique 10 est en Ti, Ta ou TaN, les résidus 11 sont formés à l'étape S11 par réaction avec un acide contenant du chlore (ex. solution aqueuse de HCI) et la couche métallique 10 est gravée à l'étape S12 par un plasma RIE à base de chlore.

Le procédé de rugosification peut comprendre en outre une étape d'oxydation de la surface de la couche métallique 10, avant l'étape S11 de formation des résidus 11. Cette oxydation préalable est avantageuse, car elle augmente la cinétique de formation des résidus 11. La surface de la couche métallique 10 peut être oxydée en l'exposant soit à l'air ambiant après le dépôt de la couche métallique 10 sur le substrat, soit à un plasma contenant de l'oxygène (de préférence dans le même réacteur plasma que celui utilisé à l'étape S11) ou en effectuant un recuit de la couche métallique 10 sous oxygène.

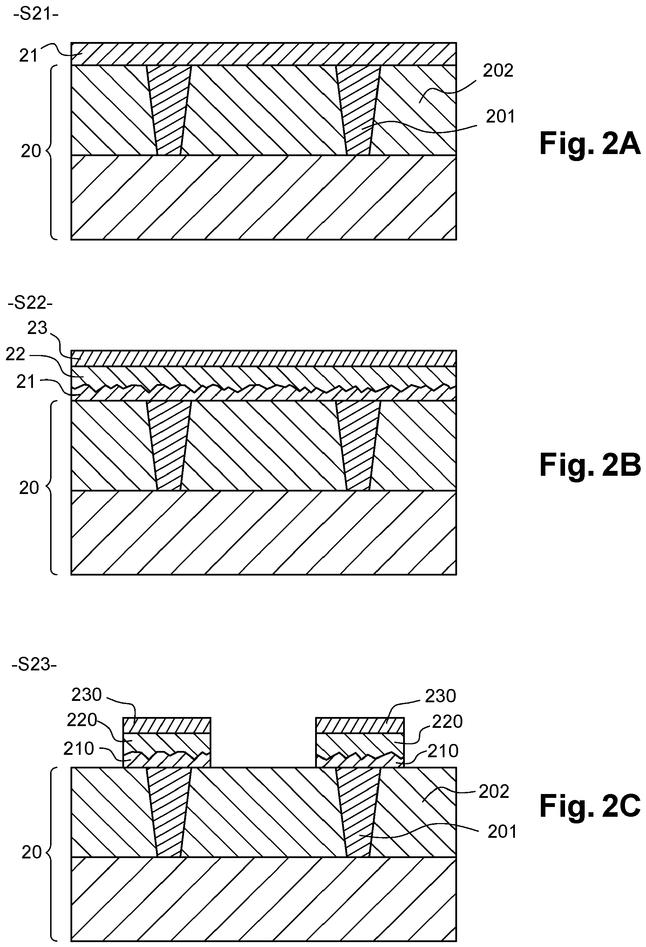

Un exemple d'application du procédé de rugosification va maintenant être décrit en relation avec les figures 2A-2C.

Cet exemple d'application concerne un procédé de fabrication d'une cellule de mémoire résistive, par exemple de type OxRAM. Une cellule mémoire résistive comprend classiquement une première électrode dite électrode inférieure, une deuxième électrode dite électrode supérieure, et une couche résistive (aussi appelée couche active) disposée entre les électrodes inférieure et supérieure. La couche résistive est formée d'un matériau à résistance électrique variable, un oxyde dans le cas d'une cellule OxRAM.

Les figures 2A à 2C représentent schématiquement des étapes S21 à S23 de ce procédé de fabrication de cellule mémoire résistive.

L'étape S21 de la figure 2A consiste à déposer une première couche métallique 21 sur un substrat 20. Par exemple, la première couche métallique 21 est formée de nitrure de titane (TiN) et son épaisseur est comprise entre 100 nm et 150 nm.

Le substrat 20 peut notamment comporter des composants actifs (ex. transistors), reliés en eux par un ou plusieurs niveaux d'interconnexion (ou niveaux de métal) pour former un circuit logique CMOS (typiquement un circuit de lecture). Chaque niveau d'interconnexion comprend des via métalliques et/ou des lignes métalliques 201 enrobés dans une ou plusieurs couches diélectriques 202.

La première couche métallique 21 est déposée sur un niveau d'interconnexion (par exemple le premier niveau de métal M1) de façon à être en contact avec les lignes métalliques 201 de ce niveau. Ainsi, dans cet exemple, la cellule mémoire est formée au sein du bloc fonctionnel BEOL (« Back End Of Line » en anglais) d'un circuit CMOS.

La rugosité de surface de la première couche métallique 21 est ensuite augmentée au moyen du procédé de rugosification décrit en relation avec les figures 1A-1B. La rugosité de surface finale de la première couche métallique 21 est avantageusement supérieure ou égale à 2 nm, de préférence comprise entre 3 nm et 15 nm, afin de diminuer de façon significative la tension de forming de la cellule mémoire.

A l'étape S22 de la figure 2B, une couche de matériau à résistance électrique variable 22 est ensuite déposée sur la première couche métallique 21, puis une deuxième couche métallique 23 est déposée sur la couche de matériau à résistance électrique variable 22. Le matériau à résistance électrique variable peut être un oxyde, de préférence un oxyde de métal de transition tel que l'oxyde d'hafnium (HfO₂). La deuxième couche métallique 22 est par exemple formée de nitrure de titane (TiN). L'épaisseur de la couche de matériau à résistance électrique variable 22 peut être comprise entre 5 nm et 20 nm et l'épaisseur de la deuxième couche métallique 22 comprise entre 100 nm et 150 nm.

Enfin, à l'étape S23 de la figure 2C, la première couche métallique 21, la couche de matériau à résistance électrique variable 22 et la deuxième couche métallique 23 sont gravées de sorte à délimiter respectivement l'électrode inférieure 210, la couche résistive 220 et l'électrode supérieure 230 de la cellule mémoire résistive. La gravure peut être réalisée par RIE à travers un masque dur ou en résine, formé par photolithographie et retiré après la gravure. La gravure de l'électrode inférieure (ex. TiN) par RIE peut être sélective par rapport à la couche diélectrique 202 (ex. SiO₂) du niveau d'interconnexion, de sorte qu'il n'y ait pas de transfert de rugosité dans cette couche diélectrique 202.

Plusieurs cellules mémoire (comprenant chacun un empilement électrode inférieure 210 - couche résistive 220 - électrode supérieure 230) peuvent être formées simultanément à l'étape de gravure S3, comme cela est illustré par la figure 2C. L'électrode inférieure 210 de chaque cellule mémoire est en contact avec une ligne métallique 201 du niveau d'interconnexion.

## Revendications

1. Procédé pour augmenter la rugosité de surface d'une couche (10) à base d'un métal ayant un pouvoir catalytique, comprenant les étapes suivantes :
- fixer (S11) du fluor ou du chlore à la surface de la couche à base de métal (10), en exposant la couche à base de métal (10) à un plasma formé à partir d'un gaz réactif contenant du fluor ou du chlore ;
- exposer (S11) la surface de la couche à base de métal (10) à un environnement humide pour produire un acide, par réaction de l'hydrogène de l'environnement humide avec le fluor ou le chlore fixé à la surface de la couche à base de métal, l'acide réagissant avec le métal pour former des résidus, l'ensemble des résidus formant un motif (12) à la surface de la couche à base de métal (10) ;
- graver (S12) la couche à base de métal (10) à travers les résidus (11), de façon à transférer le motif (12) dans la couche à base de métal (10).

2. Procédé selon la revendication 1, dans lequel la couche à base de métal (10) est gravée au moyen d'un procédé de gravure ayant une sélectivité par rapport aux résidus (11) comprise entre 1 et 2.

3. Procédé selon l'une des revendications 1 et 2, dans lequel la couche à base de métal (10) est gravée jusqu'à retirer tous les résidus (11).

4. Procédé selon l'une quelconque des revendications 1 à 3, dans lequel le gaz réactif est un gaz non polymérisant contenant du fluor, par exemple l'hexafluorure de soufre (SF₆) ou le trifluorure d'azote (NF₃).

5. Procédé selon l'une quelconque des revendications 1 à 3, dans lequel le plasma est formé à partir d'un mélange de gaz réactifs comprenant un gaz fluorocarboné (CₓF_{Y}) et un gaz dépolymérisant.

6. Procédé selon l'une quelconque des revendications 1 à 5, dans lequel l'environnement humide est l'air ambiant.

7. Procédé selon l'une quelconque des revendications 1 à 5, dans lequel l'environnement humide est généré dans une chambre d'un réacteur plasma.

8. Procédé selon l'une quelconque des revendications 1 à 7, comprenant en outre une étape d'oxydation de la surface de la couche à base de métal (10) avant l'étape de formation des résidus (11).

9. Procédé selon l'une quelconque des revendications 1 à 8, dans lequel le métal est choisi parmi le titane (Ti), le nitrure de titane (TiN), le tantale (Ta) et le nitrure de tantale (TaN).

10. Procédé de fabrication d'une cellule mémoire résistive comprenant une première électrode (210), une deuxième électrode (230) et une couche résistive (220) disposée entre les première et deuxième électrodes, le procédé comprenant les étapes suivantes :
- déposer (S21) une première couche métallique (21) sur un substrat ;
- augmenter la rugosité de la première couche métallique (21) au moyen d'un procédé selon l'une quelconque des revendications 1 à 9 ;
- déposer (S22) une couche de matériau à résistance électrique variable (22) sur la première couche métallique (21) et une deuxième couche métallique (23) sur la couche de matériau à résistance électrique variable ;
- graver (S23) la première couche métallique (21), la couche de matériau à résistance électrique variable (22) et la deuxième couche métallique (23), de façon à délimiter respectivement la première électrode (210), la couche résistive (220) et la deuxième électrode de la cellule mémoire résistive (230).
